# EUROPEAN PATENT APPLICATION

(11) **EP 2 680 369 A1**
(43) Date of publication of application: **01.01.2014**
(21) Application number: 13173294.3
(22) Date of filing: 21.06.2013
(51) Int. Cl.: H01R 12/71, H01R 13/24, H01R 12/57

(54) **Contact member**

(30) Priority: 29.06.2012 JP 2012147384
(71) Applicant: Fujitsu Component Limited, Tokyo 141-8630 (JP)
(72) Inventor: Kiryu, Koichi, Nagano, 389-2500 (JP); Shimizu, Manabu, Tokyo, 141-8630 (JP)
(74) Representative: Stebbing, Timothy Charles

(57) **Abstract**

A contact member (1) that electrically connects a first board (100) and a second board (200) includes a first joining part (2) including a first surface to be joined to the first board (100), a contact point part (15a) to come into contact with the second board (200), a first contact part (9a) that faces and comes into contact with a second surface of the first joining part (2) opposite to the first surface, a first bent portion formed by bending a portion of the contact member (1) between the first joining part (2) and the first contact part (9a), a second bent portion formed by bending a portion of the contact member (1) between the first contact part (9a) and the contact point part (15a) in a direction opposite to a direction in which the first bent portion is bent, and an attracted part (15) that extends from the contact point part (15a) in a direction away from the second bent portion.

## Description

### BACKGROUND OF THE INVENTION

### 1. Field of the Invention

The present invention relates to a contact member.

### 2. Description of the Related Art

Electronic apparatuses such as cellular phones and smartphones have been reduced in size and thickness, and in response to this, the form of mounting parts on a printed circuit board (hereinafter abbreviated to "board") provided inside apparatuses has mostly shifted to the surface mounting of chip parts.

In these electronic apparatuses, a ground (GND) line of the board is connected to a conductor panel of the enclosure (so-called frame grounding [FG]) in order to protect electronic parts mounted on the board and to deal with noise. Frame grounding is also performed between boards. In this case, a surface-mount contact member is used to connect respective conductors of the boards.

Usually, an automatic mounting apparatus is used to mount electronic parts on the surface of a board. In the case of a large electronic part, the automatic mounting apparatus holds the electronic part by clamping the electronic part with claws, and mounts the electronic part at a predetermined position. On the other hand, in the case of a small electronic part, the electronic part is held by attraction and adhesion using a suction nozzle. Accordingly, such a small electronic part subjected to mounting by the automatic mounting apparatus has an attracted part that is attracted and adhered to a suction nozzle.

Furthermore, it is desired that a contact member used for frame grounding be connected to a board with electrical stability. Therefore, while there has been a demand for size reduction, the design of the shape of a spring member has become important.

Such conventional contact members used for surface mounting include the following.

For example, Patent Document 1 (Japanese Laid-Open Patent Application No. 2009-272237) discloses a surface-mount contact with an attracted surface that is attracted and adhered to a suction nozzle.

Patent Document 2 (Japanese Laid-Open Patent Application No. 2002-015801) discloses a contact member provided with an attracted surface part.

### SUMMARY OF THE INVENTION

According to an aspect of the present invention, a contact member that electrically connects a first board and a second board includes a first joining part including a first surface to be joined to the first board; a contact point part to come into contact with the second board; a first contact part that faces and comes into contact with a second surface of the first joining part opposite to the first surface; a first bent portion formed by bending a portion of the contact member between the first joining part and the first contact part; a second bent portion formed by bending a portion of the contact member between the first contact part and the contact point part in a direction opposite to a direction in which the first bent portion is bent; and an attracted part that extends from the contact point part in a direction away from the second bent portion.

### BRIEF DESCRIPTION OF THE DRAWINGS

FIGS. 1A, 1B, 1C, 1D, 1E, and 1F are a plan view, a left side view, a front view, a right side view, a bottom view, and a perspective view, respectively, of a contact member according to a first embodiment;
FIG. 2 is a cross-sectional view of the contact member, taken along a plane including line A-A in FIG. 1D;
FIGS. 3A through 3C are diagrams illustrating a displacement of the contact member according to the first embodiment;
FIG. 4 is an enlarged view of a contact point part according to the first embodiment;
FIGS. 5A, 5B, 5C, 5D, 5E, and 5F are a plan view, a left side view, a front view, a right side view, a bottom view, and a perspective view, respectively, of a contact member according to a second embodiment;
FIGS. 6A and 6B are diagrams illustrating the mounting of a contact member on a board according to the second embodiment;
FIGS. 7A and 7B are a perspective view and a bottom view, respectively, of a contact member according to the second embodiment;
FIGS. 8A and 8B are a perspective view and a bottom view, respectively, of a contact member according to the second embodiment; and
FIG. 9 is a diagram illustrating soldering of a contact member.

### DESCRIPTION OF THE EMBODIMENTS

As described above, Patent Document 1 and Patent Document 2 illustrate conventional contact members with an adhesion and attraction surface. However, according to these contact members, the attracted surface is provided at a position that is displaceable with a single spring. Therefore, when a suction nozzle of an automatic mounting apparatus presses the attracted surface, the attracted surface tilts with the bending of the single spring. Accordingly, a gap may be formed between the end of the nozzle and the contact member, thus causing a vacuum leak to end up in attraction failure. Specifically, in Patent Document 1, the upper surface of a surface-mount contact is an attracted surface, and the attracted surface tilts with the bending of a bent part. Likewise, in Patent Document 2, the attracted surface part of a metal terminal part is caused to tilt by the bending of a spring part, thus making the attracted surface less attractable.

According to an aspect of the present invention, a contact is provided that has better attractability in an automatic mounting apparatus and has good electrical characteristics.

A description of embodiments of the present invention is given below with reference to the accompanying drawings.

### [a] First Embodiment

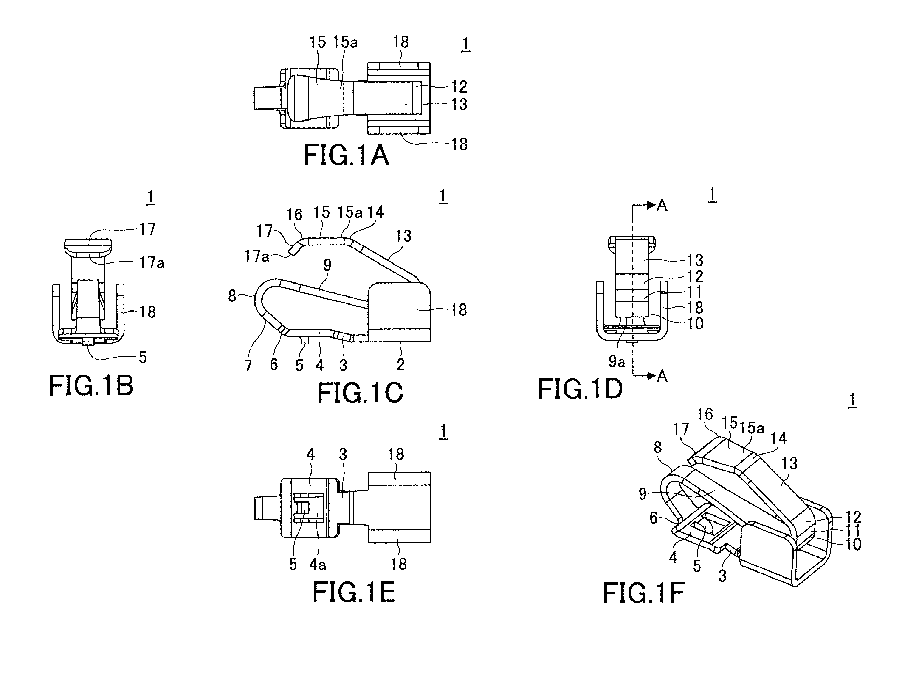

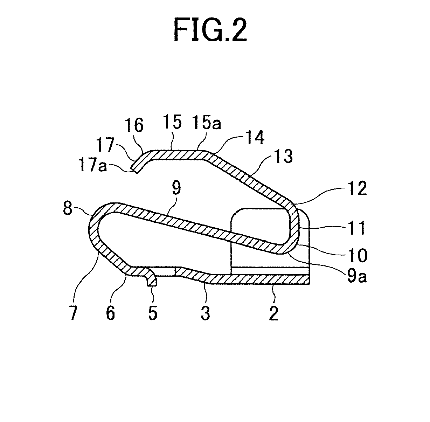

FIGS. 1A through 1F and FIG. 2 are diagrams illustrating a contact member according to a first embodiment. FIGS. 1A, 1B, 1C, 1D, 1E, and 1F are a plan view, a left side view, a front view, a right side view, a bottom view, and a perspective view, respectively, of a contact member 1 according to the first embodiment. FIG. 2 is a cross-sectional view of the contact member 1, taken along a plane including line A-A in FIG. 1D.

The contact member 1 according to this embodiment has a spring characteristic and electrically connects respective contacts of two boards.

As a material for the contact member 1, an electrically-conductive metal plate of, for example, phosphor bronze, beryllium copper, or stainless steel is used that has a spring characteristic. The contact member 1 is formed by processing a metal leaf spring of, for example, 0.08 mm to 0.15 mm in thickness into the graphically illustrated shape by press working. Furthermore, the contact member 1 may be partly or entirely plated with nickel, copper, or gold as desired.

In order to describe the directions of bending of a leaf spring by press working, a direction in which a surface of the leaf spring on the same side as an attracted part 15 (of the contact member 1) is bent inward (folded in "valley fold") in FIG. 1 is referred to as "first bending direction" and a direction in which a surface of the leaf spring on the same side as the attracted part 15 is bent outward (folded in "mountain fold") in FIG. 1 is referred to as "second bending direction."

Referring to FIGS. 1A through 1F, the contact member 1 includes a first joining part 2 to be joined to a board surface by, for example, soldering, a rising part 3 that is bent in the first bending direction from the first joining part 2 to rise from the board surface, an intermediate part 4 that is continuous with the rising part 3 and is spaced from the board surface, and a second joining part 5 that extends from an opening part 4a formed in the intermediate part 4 to come into contact with the board surface. The opening part 4a is a part of the intermediate part 4 that has become an opening as a result of the piercing of the intermediate part 4 by pressing, with the second joining part 5 being left. Referring to FIG. 1C, the second joining part 5 is so bent as to extend downward from a surface of the intermediate part 4. The second joining part 5 may either come into contact with the board surface at the same vertical position as the first joining part 2 or be slightly above the board surface.

The contact member 1 further includes a first bent part 6 that is bent obliquely upward in the first bending direction from the intermediate part 4 in FIG. 1C, a first spring part 7 that is continuous with the first bent part 6, a second bent part 8 that is continuous with the first spring part 7 and is bent in the first bending direction, and a second spring part 9 that is continuous with the second bent part 8.

The first bent part 6, the first spring part 7, the second bent part 8, and the second spring part 9 form a "first bent portion" of the contact member 1. The first bent portion has a first spring constant. The first spring constant may be determined by the shape of the first bent portion.

The second spring part 9 includes a first contact part 9a that approaches and contacts an upper surface of the first joining part 2 as a result of the bending of the first bent portion.

The contact member 1 further includes a third bent part 10 that is continuous with the second spring part 9 and is bent in the second bending direction, a third spring part 11 that is continuous with the third bent part 10, a fourth bent part 12 that is continuous with the third spring part 11 and is bent in the second bending direction, a fifth spring part 13 that is continuous with the fourth bent part 12, and a fifth bent part 14 that is continuous with the fifth spring part 13 and is bent in the second bending direction.

The third bent part 10, the third spring part 11, the fourth bent part 12, and the fifth spring part 13 form a "second bent portion" of the contact member 1. The second bent portion has a second spring constant. The second spring constant may be determined by the shape of the second bent portion.

The contact member 1 includes the attracted part 15 that is continuous with the fifth bent part 14. The attracted part 15 includes a surface that is substantially parallel to the first joining part 2 and is attracted and adhered to a suction nozzle of an automatic mounting apparatus by its pickup operation. The attracted part 15 includes a contact point part 15a that comes into contact with a conductor of a board frame. The attracted part 15 may have a larger width than the second bent portion.

The contact point part 15a may be attracted by the suction nozzle.

The contact member 1 further includes a sixth bent part 16 that is continuous with the attracted part 15 and is bent in the second bending direction and an end portion 17 that is continuous with the sixth bent part 16 and is configured to approach and contact the second spring part 9. The end part 17 includes a second contact part 17a that comes into contact with the second spring part 9 as a result of the bending of the second bent portion. In using the contact member 1, however, the second contact part 17a does not have to come into contact with the second spring part 9, and the second bent portion may be configured to bend up to a position at which the second bent portion stops bending before the second contact part 17a comes into contact with the second spring part 9.

The contact member 1 further includes protection parts 18 that are bent from the first joining part 2 to rise from a surface of the first joining part 2. The protection parts 18 serve as a guide for proper bending of the first bent portion of the contact member 1, and may also be used as a holding position in a clamping device of an automatic mounting apparatus.

As described above, according to the first embodiment, bent parts and spring parts are integrally formed. The bent parts and spring parts of the first bent portion and the second bent portion, however, are not limited to the above-described configuration. For example, the first bent part 6, the first spring part 7, the second bent part 8, and the second spring part 9 may be formed as a single bent portion having the first spring constant. Likewise, the second bent portion as well is not limited to the shape illustrated in this embodiment. The shapes of the bent portions in this embodiment are examples of shapes as a contact member according to the first embodiment.

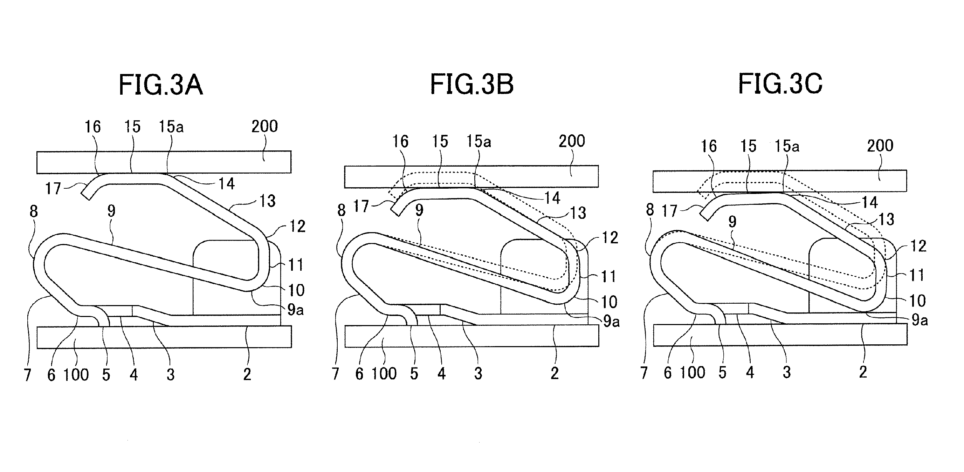

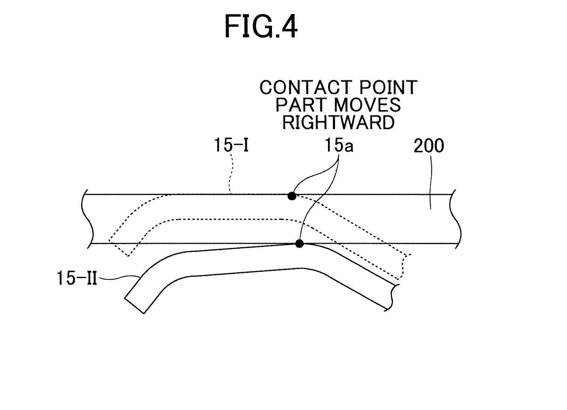

Next, a description is given, with reference to FIGS. 3A, 3B, and 3C and FIG. 4, of the displacement of the contact member 1 according to the first embodiment. FIGS. 3A through 3C are diagrams sequentially illustrating, from FIG. 3A to FIG. 3C, a displacement of the contact member 1 mounted on a surface of a first board 100 as the contact member 1 according to the first embodiment is pressed by a second board 200. In FIGS. 3A through 3C, the first board 100 has an electrically conductive part (not illustrated) on its upper surface. The contact member 1 is mounted on the upper surface of the first board 100 with the first joining part 2 being joined to the electrically conductive part on the upper surface by soldering or the like. An upper part of the contact member 1 is in contact with an electrically conductive part (not illustrated) provided on a lower surface of the second board 200. As a result, frame grounding (FG) is established between the first board 100 and the second board 200.

FIG. 3A illustrates a state where the second board 200 has first come into contact with the contact member 1. In FIG. 3A, the contact member 1 has not received a downward force from the second board 200, and the contact member 1 is not displaced. Accordingly, the attracted part 15 is substantially horizontal so as to have a large area of contact with the electrically conductive part on the lower surface of the second board 200.

FIG. 3B illustrates a state at a time when the second board 200 is depressed. In this embodiment, the first spring constant is determined to be smaller than the second spring constant. Therefore, when a downward force is applied to the attracted part 15 by the second board 200, the first bent portion having a smaller spring constant bends more than the second bent portion having a larger spring constant.

How the bending of the first bent portion and the bending of the second bent portion affect the inclination of the attracted part 15 is described. When the first bent portion bends, the surface of the attracted part 15 rotates (moves) clockwise. On the other hand, when the second bent portion bends, the surface of the attracted part 15 rotates (moves) counterclockwise. Accordingly, when both the first bent portion and the second bent portion bend, the rotation directions of the attracted part 15 cancel out. Therefore, even when the entire contact member 1 is compressed by the pressure of the second board 200, the surface of the attracted part 15 is likely to be kept in a horizontal position. That is, this movement may be obtained by providing the attracted part 15 ahead of the first bent portion and the second bent portion. When the contact member 1 is depressed by the second board 200, the contact member 1 moves in the same manner in the case where a suction nozzle of an automatic mounting apparatus depresses the attracted part 15. That is, even when the suction nozzle is pressed against the attracted part 15, the surface of the attracted part 15 is less likely to be inclined, so that it is possible to reduce attraction errors.

The first spring constant and the second spring constant may be suitably determined in accordance with mechanical characteristics desired of the contact member 1. For example, when the first spring constant is determined to be an even smaller value than the second spring constant, it is possible to cause the second bent portion to hardly bend before the first bent portion bends to have the first contact part 9a coming into contact with and stopped by the first joining part 2. On the other hand, when the first spring constant and the second spring constant are closer, the second bent portion also considerably bends in accordance with the second spring constant before the first contact part 9a is stopped by the first joining part 2.

The attracted part 15 is positioned so as not to affect the respective spring constants of the first bent portion and the second bent portion. Therefore, in designing the respective shapes of the first bent portion and the second bent portion, the shape of the attracted part 15 may not be taken into consideration in determining the spring performance.

FIG. 3C illustrates how the first contact part 9a comes into contact with and is stopped by the first joining part 2. The first contact part 9a reaches and is stopped by the first joining part 2 by a force commensurate to the first spring constant of the first bent portion and a distance from the first contact part 9a to the first joining part 2.

The contact of the first contact part 9a with the first joining part 2 shortens the electrical distance of a conductor, so that it is possible to reduce impedance. This reduction in impedance is particularly effective in the frame grounding of boards that use high frequencies.

When the second board 200 is further depressed so as to be closer to the first board 100, the second bent portion bends, so that the second contact part 17a approaches the second spring part 9. At this point, the attracted part 15 rotates counterclockwise substantially about the first contact part 9a to be inclined. Therefore, with the inclination of the attracted part 15, a position of the electrically conductive part of the second board 200 at which the contact point part 15a comes into contact with the electrically conductive part gradually changes. This causes friction between the contact point part 15a and the electrically conductive part of the second board 200, so that an oxide film on the surface of a contact point is removed by a frictional force in the contact point part 15a. Thus, a so-called wiping effect is produced, so that it is possible to improve the performance of a contact point.

FIG. 4 is an enlarged view of the contact point part 15a. In FIG. 4, the initial position of the attracted part 15 is denoted by 15-I. The attracted part 15 is substantially horizontal (parallel to the upper surface of the first board 100) at the initial position 15-I, while at a position 15-II, where the second board 200 is most depressed, the attracted part 15 is rotated counterclockwise relative to the initial position 15-I with the bending of the second bent portion, so as to be inclined toward the lower left in FIG. 4. Therefore, the contact point part 15a moves its position of contact with the second board 200 in the rightward direction in accordance with the angle of inclination of the attracted part 15.

### [b] Second Embodiment

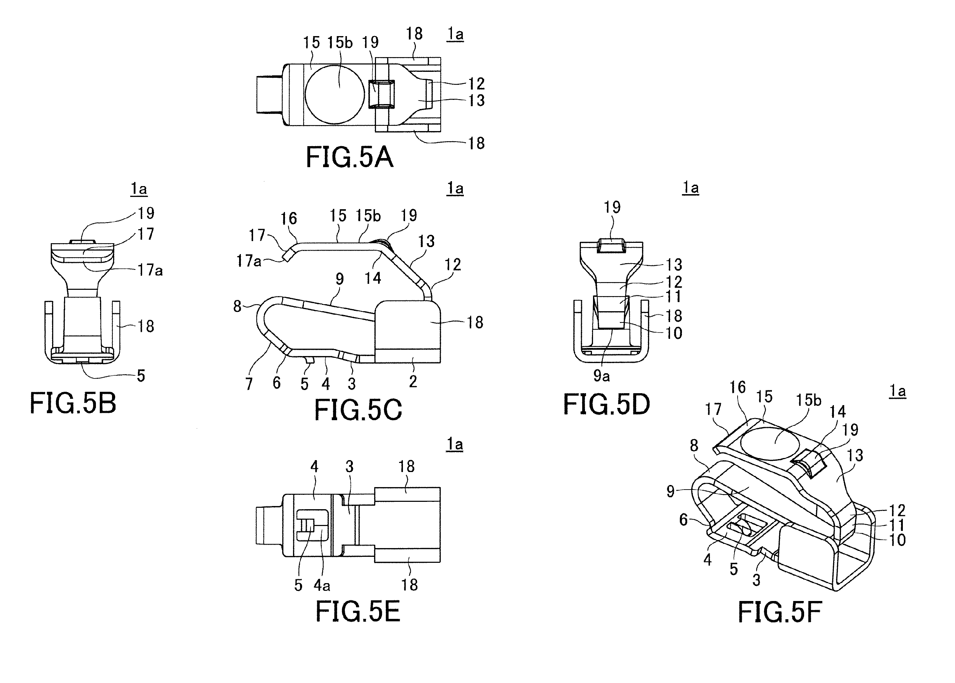

FIGS. 5A through 5F are diagrams illustrating a contact member according to a second embodiment. FIGS. 5A, 5B, 5C, 5D, 5E, and 5F are a plan view, a left side view, a front view, a right side view, a bottom view, and a perspective view, respectively, of a contact member 1a according to the second embodiment. In the contact member 1a according to the second embodiment, the same parts as those of the contact member 1 according to the first embodiment are referred to by the same reference numerals, and their description is omitted.

Referring to FIGS. 5A through 5F, the contact member 1a includes a smoothed part 15b, which is a smoothed part of the upper surface of the attracted part 15. The smoothed part 15b is smoothed by pressing. Alternatively, the smoothed part 15b may also be smoothed by grinding, blasting, or plating. The smoothed part 15b may cause the contact member 1a to be more reliably attracted and adhered to a suction nozzle of an automatic mounting apparatus.

Furthermore, the contact member 1a includes a contact point part 19. The contact point part 19 has a shape projecting from the surface of the attracted part 15. The shape of the contact point part 19 improves the contact of the contact point part 19 with the lower surface of the second board 200 when the second board 200 is depressed as illustrated in FIGS. 3A through 3C. Furthermore, the contact point part 19 may be reduced in bending radius compared with the fifth bent part 14, so that the area of contact with the second board 200 is smaller in the contact point part 19 than in the contact point part 15a described in the first embodiment. As a result of the smaller area of contact of the contact point part 19 with the second board 200, a stronger contact pressure is generated between the contact point part 19 and the second board 200 so as to increase the wiping effect.

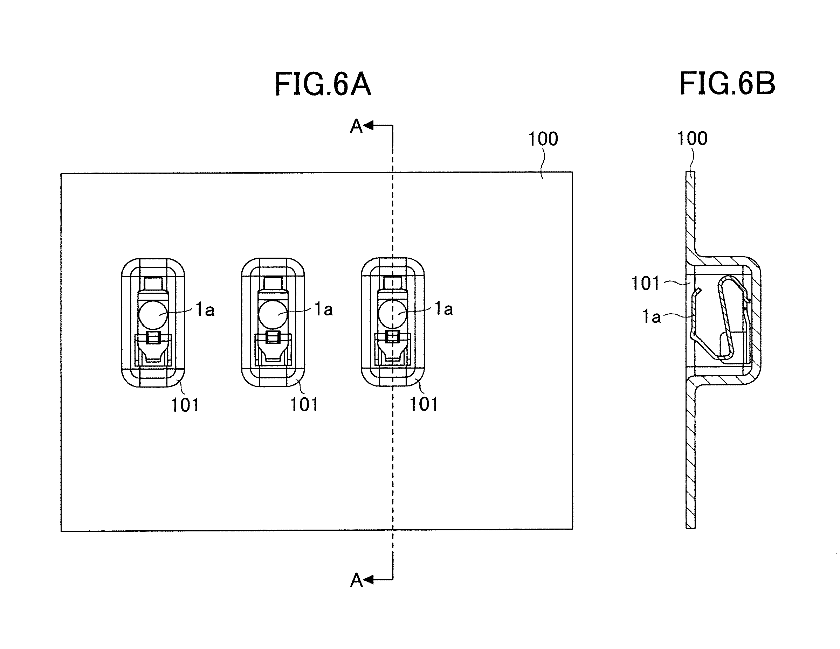

FIGS. 6A and 6B are diagrams illustrating the mounting of the contact member 1a according to the second embodiment illustrated in FIGS. 5A through 5F on the first board 100. FIG. 6B is a cross-sectional view of FIG. 6A taken along a plane including line A-A. Referring to FIGS. 6A and 6B, the contact member 1a is enclosed in each recess 101 formed in the first board 100. This mounting method enables frame grounding also in mounting in the case of joining a board that is in contact with the contact point part 19 and the first board 100.

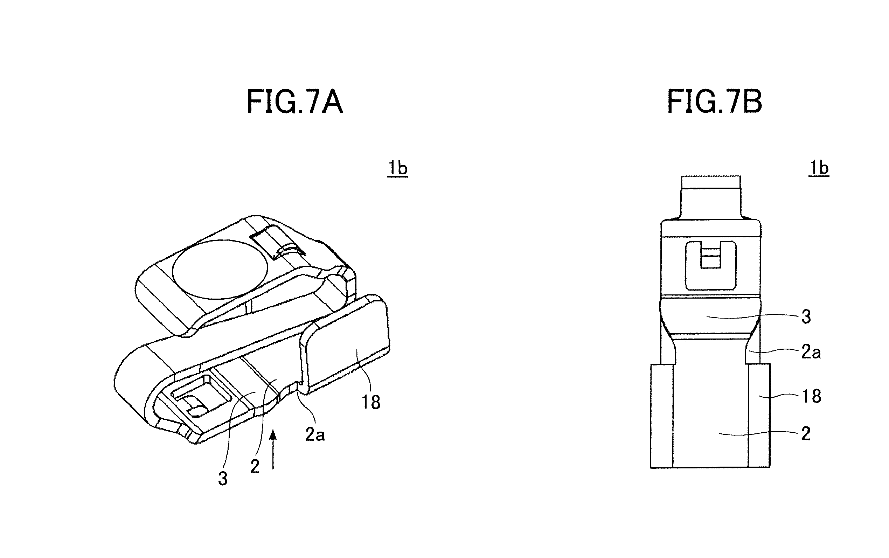

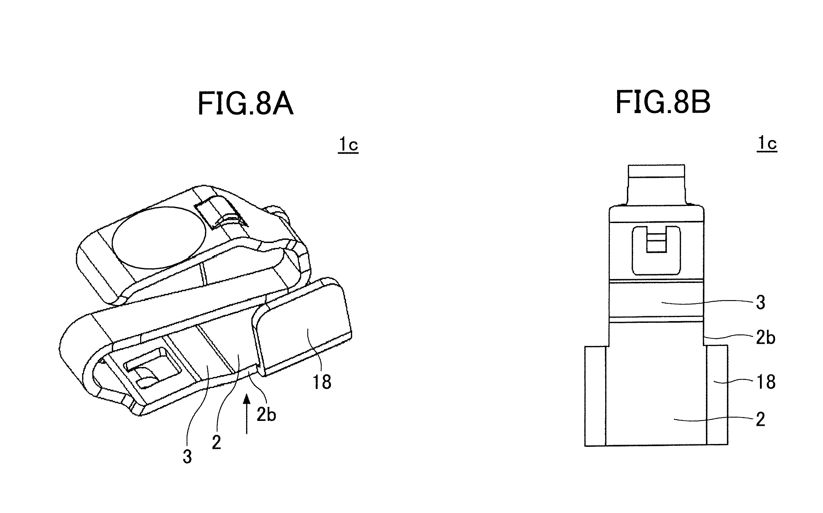

A description is given, with reference to FIGS. 7A and 7B and FIGS. 8A and 8B, of variations of a method of raising the protection parts 18 from a surface of the first joining part 2 of a contact member.

FIGS. 7A and 7B are a perspective view and a bottom view (in a direction indicated by an arrow in FIG. 7A), respectively, of a contact member according to the second embodiment, illustrating a first variation of the method of raising the protection parts 18 of a contact member. FIGS. 8A and 8B are a perspective view and a bottom view (in a direction indicated by an arrow in FIG. 8A), respectively, of a contact member according to the second embodiment, illustrating a second variation of the method of raising the protection parts 18 of a contact member.

Referring to FIGS. 7A and 7B, the first joining part 2 includes a tapered part 2a that is gradually reduced in width in a direction away from the rising part 3. The protection parts 18 are raised from part of the contact member 1b where the width is reduced by the tapered part 2a. This allows the space between the two protection parts 18, in which the second spring part 9 or the third bent part 10 is caused to move up and down by the bending of the first bent portion, to be designed to be narrow.

On the other hand, referring to FIGS. 8A and 8B, the first joining part 2 of a contact member 1c includes a linear part 2b that has the same width as the rising part 3. The protection parts 18 are raised with a wider space than in the first variation illustrated in FIGS. 7A and 7B. In the second variation, the protection parts 18 may support a wider second spring part 9 or third bent part 10 than the protection parts 18 of the first variation illustrated in FIGS. 7A and 7B. Furthermore, since there is no need to provide a tapered part, the second variation may simplify press working for a contact member.

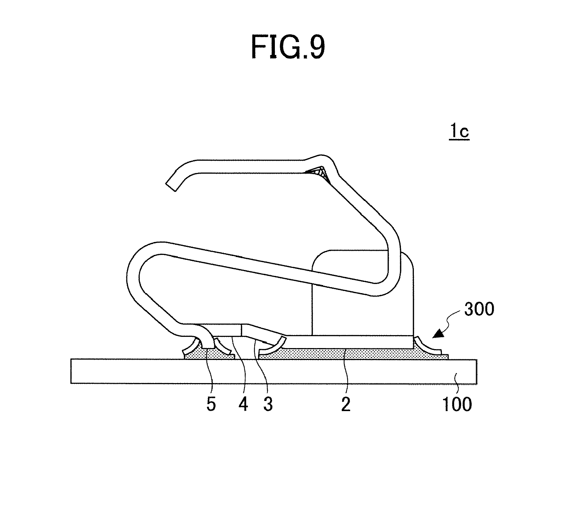

Next, a description is given, with reference to FIG. 9, of a method of soldering a contact member.

FIG. 9 is a diagram illustrating soldering of a contact member. By way of example, FIG. 9 illustrates the contact member 1c described in the second embodiment. Referring to FIG. 9, the contact member 1c has the first joining part 2 and the second joining part 5 placed on an electrically conductive part of the first board 100 on which solder paste 300 is printed, by a suction nozzle of an automatic mounting apparatus (not illustrated). By heating the first board 100, the contact member 1c is soldered to the first board 100 at the first joining part 2 and the second joining part 5.

The contact member 1c includes the rising part 3, which is bent from the first joining part 2 to rise from the surface of the first board 100, the intermediate part 4, which is spaced from the surface of the first board 100, and the second joining part 5 which extends from the opening part 4a of the intermediate part 4 to be joined to the surface of the first board 100. Therefore, an air gap is formed between the surface of the first board 100 and the intermediate part 4, and solder or flux provided in this air gap is prevented from moving up from the first board 100 to the contact member 1c. Accordingly, it is possible to prevent problems such as so-called solder wicking or flux wicking, which causes solder or flux to adhere to a surface of the contact member 1c other than its surface facing the first board 100.

In FIG. 9, soldering is performed on the entire surface of the first joining part 2 that is joined to the first board 100. Alternatively, soldering may be performed in a spot manner on part of the surface of the first joining part 2.

Furthermore, in FIG. 9, the second joining part 5 has a given length so that the second joining part 5 comes into contact with the first board 100 at the same vertical position as the bottom surface of the first joining part 2. Alternatively, the second joining part 5 may be slightly reduced in length.

If the second joining part 5 has a length larger than the given length so that the second joining part 5 projects toward the first board 100 relative to the first joining part 2, the bottom surface of the first joining part 2 that is in contact with the first board 100 may come off the first board 100. However, by having the second joining part 5 designed to have a length slightly smaller than the given length, the first joining part 2 is prevented from coming off the first board 100 even if the length of the second joining part 5 includes processing error, as long as the error does not cause the second joining part 5 to have a length larger than the given length.

Furthermore, in FIG. 9, the first joining part 2 and the second joining part 5 are soldered at a distance from each other. This reduces the area of contact with the first board 100 so that it is possible to reduce the amount of solder for soldering the contact member 1c, compared with the case where the first joining part 2 extends to the first bent part 6 without the rising part 3, the intermediate part 4, and the second joining part 5, and the entire bottom surface of the extended first joining part 2 comes into contact with the surface of the first board 100, for example.

Furthermore, even in the case where the coefficient of thermal expansion differs between the first board 100 and the contact member 1c, an extended portion of the second joining part 5 having an extending shape deforms to eliminate the difference in expansion due to heat, so that it is possible to eliminate the distortion of the contact member 1c at the time of soldering.

All examples and conditional language provided herein are intended for pedagogical purposes of aiding the reader in understanding the invention and the concepts contributed by the inventors to further the art, and are not to be construed as limitations to such specifically recited examples and conditions, nor does the organization of such examples in the specification relate to a showing of the superiority or inferiority of the invention. Although one or more embodiments of the present invention have been described in detail, it should be understood that the various changes, substitutions, and alterations could be made hereto without departing from the spirit and scope of the invention.

For example, multiple joining parts that are shaped to extend toward a board surface like the second joining part 5 may be provided in contact members.

Furthermore, part of the first joining part 2 may be removed by piercing in order to reduce an area of placement of the first joining part 2 on a board.

Various aspects of the subject matter described herein may be set out non-exhaustively in, for example, a contact member including a first joining part including a lower surface to be joined to a first board; a contact point part to come into contact with a second board; a rising part that rises from the first joining part; an intermediate part that is continuous with the rising part and is separated from the first board; a second joining part that extends from the intermediate part to be joined to the first board; a first contact part that faces and comes into contact with an upper surface of the first joining part; a first bent portion formed by bending a leaf spring, the first bent portion being interposed between the first joining part and the first contact part and configured to be stopped by the first contact part coming into contact with the upper surface of the first joining part; and a second bent portion formed by bending the leaf spring in a direction opposite to a direction in which the leaf spring is bent to form the first bent portion, the second bent portion being interposed between the first contact part and the contact point part.

## Claims

1. A contact member that electrically connects a first board and a second board, **characterized by**:
a first joining part including a first surface to be joined to the first board;
a contact point part to come into contact with the second board;
a first contact part that faces and comes into contact with a second surface of the first joining part opposite to the first surface;
a first bent portion formed by bending a portion of the contact member between the first joining part and the first contact part;
a second bent portion formed by bending a portion of the contact member between the first contact part and the contact point part in a direction opposite to a direction in which the first bent portion is bent; and
an attracted part that extends from the contact point part in a direction away from the second bent portion.

2. The contact member as claimed in claim 1, further **characterized by**:
an intermediate part interposed between the first joining part and the first bent portion, wherein the intermediate part is so formed as to be spaced from the first board when the contact member is placed on the first board; and
a second joining part to be joined to the first board, the second joining part extending from the intermediate part.

3. The contact member as claimed in claim 1 or 2, **characterized in that** the attracted part is substantially parallel to the first joining part.

4. The contact member as claimed in any of claims 1 to 3, **characterized in that** the attracted part includes a smoothed surface.

5. The contact member as claimed in any of claims 1 to 4, **characterized in that** the attracted part has a larger width than the second bent portion.

6. The contact member as claimed in any of claims 1 to 5, **characterized in that** the contact point part has a shape projecting from the attracted part.
